# EUROPEAN PATENT SPECIFICATION

(11) **EP 2 844 055 B1**
(45) Date of publication and mention of the grant of the patent: **02.09.2020**
(21) Application number: 12875470.2
(22) Date of filing: 27.04.2012
(51) Int. Cl.: H05K 13/02, H01L 21/67, H01L 21/677, H01L 21/683, H01L 21/687

(54) **DEVICE FOR ATTACHING COMPONENT SUPPLY UNIT OF COMPONENT MOUNTING MACHINE**
VORRICHTUNG ZUR BEFESTIGUNG EINER BAUTEILZUFÜHREINHEIT EINER BAUTEILBESTÜCKUNGSMASCHINE
DISPOSITIF DE FIXATION D'UNE UNITÉ D'ALIMENTATION EN COMPOSANT D'UNE MACHINE DE MONTAGE DE COMPOSANT

(43) Date of publication of application: 04.03.2015
(73) Proprietor: FUJI Corporation, Chiryu Aichi (JP)
(72) Inventor: YAMASAKI, Toshihiko, Chiryu Aichi (JP); OHASHI, Hiroyasu, Chiryu Aichi (JP); SHIMIZU, Toshinori, Chiryu Aichi (JP); MURAI, Masaki, Chiryu Aichi (JP)
(74) Representative: Grünecker Patent- und Rechtsanwälte PartG mbB
(86) International application number: PCT/JP2012/061427
(87) International publication number: WO 2013/161071

(56) References cited:
- DE-A1- 10 214 262
- DE-A1-102005 025 802
- DE-A1-102008 049 342
- JP-A- H0 983 195
- JP-A- H0 983 195
- JP-A- 2001 156 492
- JP-A- 2001 291 992
- JP-A- 2005 015 070
- JP-A- 2011 119 430
- US-A1- 2002 021 934

## Description

### Technical Field

The present invention relates to a device for attaching a component supply unit to a component mounting machine by inserting the component supply unit, which includes casters, into a unit attachment space of the component mounting machine.

### Background Art

There are various types of component supply units that supply components to a component mounting machine.

**For example, there is an electronic-component mounting apparatus (see PTL 1) in which a table can be easily replaced. To this end, the electronic-component mounting apparatus is provided with a cylinder for pulling a base section of the table into an interior space of the apparatus and a clamp for clamping the table.**

**Further,** there is a component supply unit (see PTLs 2 and 3) in which a plurality of tape feeders are mounted on a cart, a component supply unit (see PTL 4) where tray pallets on which tray components are stacked are received in a magazine in multiple stages, a component supply unit (see PTL **5)** where wafers are received in multiple stages, a component supply unit (see PTL **6**) in which wafer pallets on which wafer components are placed and tray pallets on which tray components are placed are placed together in multiple stages, and the like. Since all of these types of component supply units have a large size and a heavy weight, casters are provided at the legs of the component supply unit. When attaching the component supply unit to the component mounting machine, a worker moves the component supply unit by pushing the component supply unit. As a result, the component supply unit is pushed into and attached to a unit attachment space of the component mounting machine.

### Citation List

### Patent Literature

**PTL 1:** JP-A-H09-83195
PTL **2:** JP-A-2011-146576
PTL **3:** JP-A-2009-266990
PTL **4:** JP-A-2002-232198
PTL **5:** JP-A-2012-33592
PTL **6:** JP-A-2010-129949

### Summary of Invention

### Technical Problem

Since the height position of the component supply unit needs to be fitted to the component mounting machine when the component supply unit is attached to the component mounting machine, a slope is formed toward the unit attachment space from the front side of the component mounting machine. Accordingly, a worker makes the component supply unit run on the slope by pushing the component supply unit, and pushes the component supply unit into the unit attachment space of the component mounting machine. However, since the weight of the component supply unit is heavy, the work of pushing the component supply unit is hard. Moreover, since the component supply unit collides with the component mounting machine while the component supply unit runs on the slope, there is also a possibility that the component supply unit may be damaged. Further, when the floor is not flat or is inclined, a worker needs to adjust the levelness of the component supply unit by adjusting the height position of each caster and this work is also very troublesome. Furthermore, since the inclination of the slope formed on the floor needs to be made to be gradual, the size of a space in which the slope is formed is increased due to the increase of the size of the slope and a space, which is required for the movement of the component supply unit, is also needed on the front side of the slope. Accordingly, a large empty space should be secured on the floor on the front side of the unit attachment space of the component mounting machine. For this reason, it is not possible to cope with space saving.

Accordingly, an object of the invention is to provide a device for attaching a component supply unit to a component mounting machine that can achieve the reduction of the labor of work of attaching the component supply unit to the component mounting machine and the shortening of the working time, can prevent damage to the device, and can perform work of attaching the component supply unit even in a relatively small working space.

### Solution to Problem

In order to achieve the object, the invention provides a device for attaching a component supply unit to a component mounting machine by inserting the component supply unit, which includes casters, into a unit attachment space of the component mounting machine. The component mounting machine includes unit-raising means for raising the component supply unit inserted into the unit attachment space, unit pull-in means for pulling the component supply unit, which has been raised by the unit-raising means, into the component mounting machine, and clamping means for lowering the component supply unit, which has been pulled in by the unit pull-in means, to a predetermined height position by the unit-raising means, and clamping the component supply unit. **Further, the clamping means includes clamping members that are provided on** the unit-raising means and receiving members that are provided on the component mounting machine, and is adapted to lower the clamping members by the unit-raising means while fixing members of the component supply unit are placed on the receiving members and the component supply unit is supported by the receiving members, and is adapted to clamp the fixing members by the clamping members while the fixing members are **interposed between the receiving members and the clamping members.**

In this structure, even though the floor of the unit attachment space of the component mounting machine is not flat or is inclined, not only a slope or the like does not need to be formed on the floor but also a worker does not need to perform work of adjusting the levelness of the component supply unit by adjusting the height of each caster and the worker has to only perform work of inserting the component supply unit into the unit attachment space of the component mounting machine. After that, it is possible to automatically perform a series of operations for raising the component supply unit by the unit-raising means, pulling the component supply unit into the component mounting machine by the unit pull-in means, lowering the component supply unit to a predetermined height position by the unit-raising means, positioning the component supply unit relative to the component mounting machine, and clamping the component supply unit by the clamping means. Accordingly, since it is possible to achieve the reduction of the labor of work of attaching the component supply unit and the shortening of the working time and to insert the component supply unit into the unit attachment space of the component mounting machine without using a slope, work of inserting the component supply unit into the unit attachment space of the component mounting machine becomes easy. Therefore, it is possible to prevent damage to the device during the work, and to perform work of attaching the component supply unit even in a relatively small working space. **Further, in this structure, a power source of the unit-raising means can be used as a power source of the clamping means. Therefore, it is possible to simplify the structure of the clamping means.**

In this case, the component supply unit may be supported by the casters so as to be movable up and down, and each of the casters may be provided with raising force assist means (for example, an elastic member such as a spring) for assisting a force for raising the component supply unit generated by the unit-raising means. According to this structure, since the force for raising the component supply unit generated by the unit-raising means can be assisted by the raising force assist means even though the weight of the component supply unit is large, the raising force of the unit-raising means can be reduced. Therefore, the unit-raising means can be made to be compact.

Further, the clamping means may include clamping members that provided on the unit-raising means and receiving members that are provided on the component mounting machine, and may be adapted to lower the clamping members by the unit-raising means while fixing members of the component supply unit are placed on the receiving members and the component supply unit is supported by the receiving members, and to clamp the fixing members by the clamping members while the fixing members are interposed between the clamping members and the
receiving members. In this structure, a power source of the unit-raising means can be used as a power source of the clamping means. Therefore, it is possible to simplify the structure of the clamping means.

Furthermore, the component mounting machine may include an insertion checking sensor that checks the insertion of the component supply unit into the unit attachment space, a raising checking sensor that checks the raising of the component supply unit, which is performed by the unit-raising means, and a pull-in checking sensor that checks the pull-in of the component supply unit, which is performed by the unit pull-in means. In this structure, the insertion of the component supply unit into the unit attachment space, the raising of the component supply unit, and the pull-in of the component supply unit can be checked by the respective checking sensors. Accordingly, the component supply unit can be more reliably attached and safety can also be improved.

In this case, the component mounting machine may include control means for controlling an operation of the unit-raising means and the unit pull-in means. The control means may be adapted to perform an operation for raising the component supply unit, which is performed by the unit-raising means, after the insertion of the component supply unit into the unit attachment space of the component mounting machine is checked by the insertion checking sensor; may **be adapted to** perform an operation for pulling in the component supply unit, which is performed by the unit pull-in means, after the completion of the operation for raising the component supply unit, which is performed by the unit-raising means is checked by the raising checking sensor; **may be adapted to** lower the component supply unit to a predetermined height position by the unit-raising means and **may be adapted to** clamp the component supply unit by the clamping means after the completion of the operation for pulling in the component supply unit is checked by the pull-in checking sensor. Here, the operation for raising the component supply unit, which is performed by the unit-raising means, may be started under the operation of a switch or the like, which is performed by a worker, as a condition.

Moreover, the component mounting machine may include a connector connection device that **is adapted to insert and connect** a connector of a communication line and/or a power line of the component mounting machine to a connector of the component supply unit while the component supply unit is clamped by the clamping means. According to this structure, it is possible to reliably achieve the connection of communication lines and/or power lines between the component mounting machine and the component supply unit while the component supply unit is clamped in the component mounting machine.

### Brief Description of Drawings

[Fig. 1] Fig. 1 is a perspective view of the appearance of a die supply unit of an embodiment of the invention.
[Fig. 2] Fig. 2 is a perspective view of the appearance of a push-up unit and the peripheral portion thereof.
[Fig. 3] Fig. 3 is a perspective view of the appearance of a wafer pallet.
[Fig. 4] Fig. 4 is a perspective view of the appearance of a unit attachment space of a component mounting machine.
[Fig. 5] Fig. 5 is a perspective view of the appearance of a caster of a component supply unit and the peripheral portion thereof.
[Fig. 6] Fig. 6 is a perspective view of the appearance of a unit insertion guide rail and the peripheral portion thereof.
[Fig. 7] Fig. 7 is a perspective view of the appearance showing a state in which inserting-positioning slide members of the component supply unit are inserted into the unit insertion guide rail.
[Fig. 8] Fig. 8 is a perspective view of the appearance showing a state in which rods of unit-raising devices move down.
[Fig. 9] Fig. 9 is a perspective view of the appearance showing a state in which the rods of the unit-raising devices move up.
[Fig. 10] Fig. 10 is a side view showing a state in which a fixing member of the component supply unit is raised by support rollers of the unit-raising devices.
[Fig. 11] Fig. 11 is a side view showing a state in which the fixing member of the component supply unit is clamped.
[Fig. 12] Fig. 12 is a perspective view of the appearance showing a state in which a unit pull-in device is operated in a direction where the component supply unit is ejected.
[Fig. 13] Fig. 13 is a perspective view of the appearance showing a state in which the unit pull-in device is operated in a direction where the component supply unit is inserted.
[Fig. 14] Fig. 14 is a perspective view of the appearance of a connector of the component supply unit and the peripheral portion thereof.
[Fig. 15] Fig. 15 is a perspective view of the appearance of a connector connection device of the component mounting machine.
[Fig. 16] Fig. 16 is a block diagram illustrating the configuration of a control system.
[Fig. 17] Fig. 17 is a flowchart illustrating the flow of processing of an automatic clamping operation control program.
[Fig. 18] Fig. 18 is a partial cross-sectional perspective view of a support structure of the caster of the component supply unit.

### Description of Embodiments

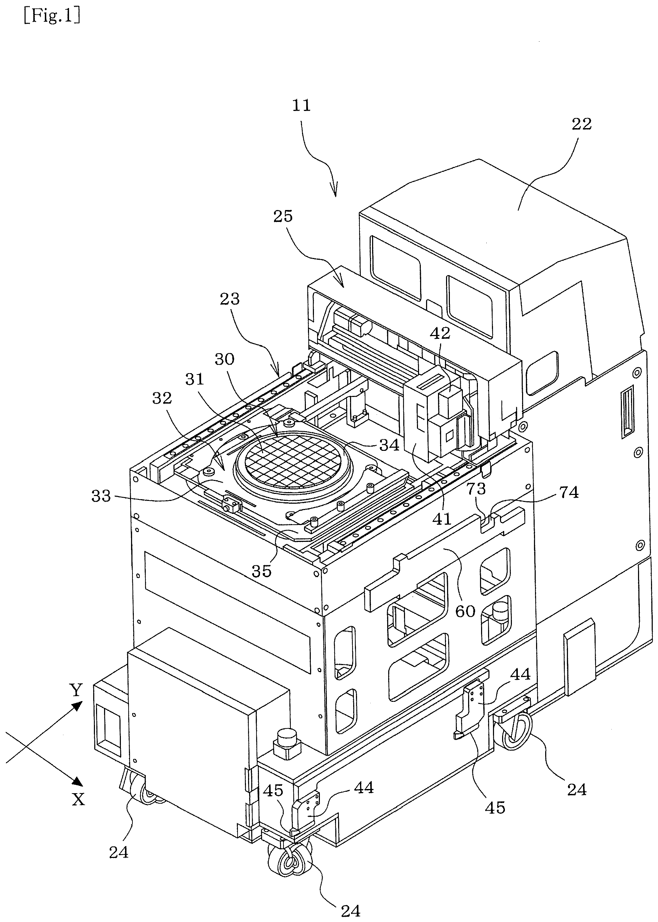

An embodiment of the invention will be described below. The structure of a component supply unit 11 will be schematically described first with reference to Figs. 1 to 3.

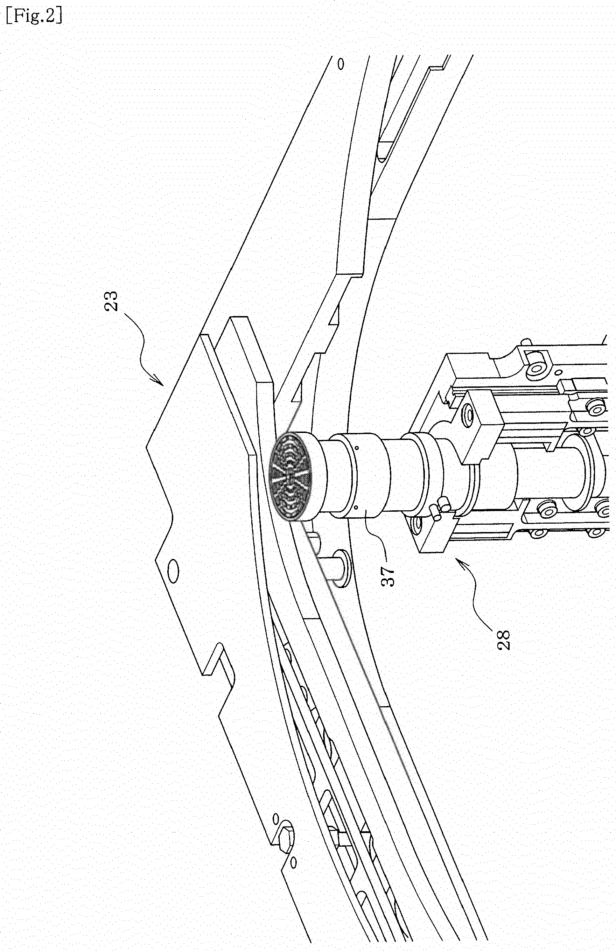

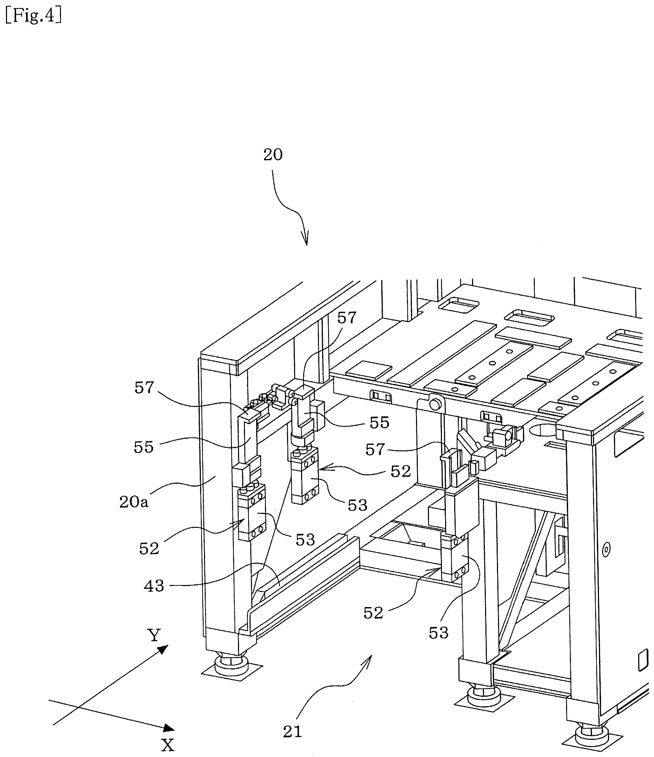

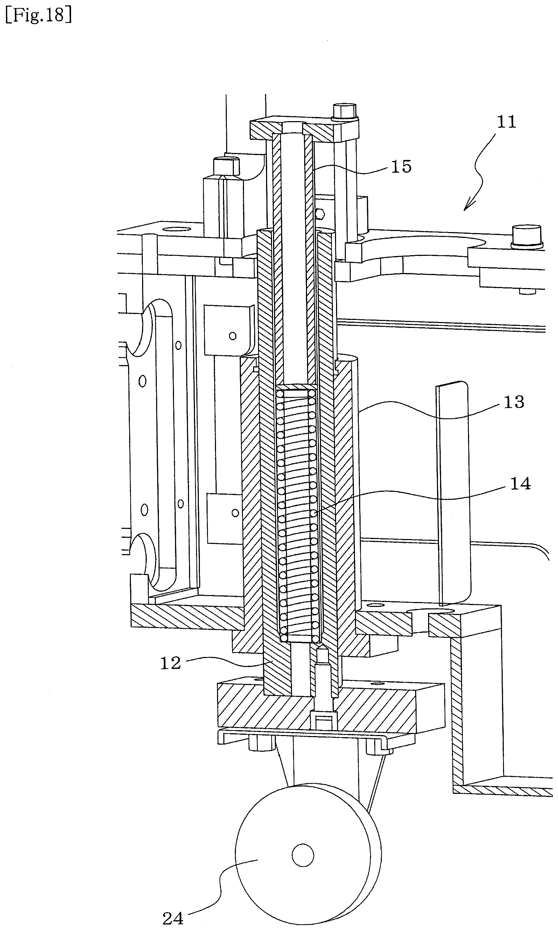

The component supply unit 11 of this embodiment is a unit that supplies dies (wafer components), and includes a magazine holder 22 (tray tower), a pallet pull-out table 23, an X-Y moving mechanism 25, a push-up unit 28 (see Fig. 2), and the like. Since the component supply unit 11 has a large size and a heavy weight, casters 24 are provided at lower end portions of a plurality of legs 12 (see Fig. 18) that support the component supply unit 11. Accordingly, a worker moves the component supply unit 11 by pushing the component supply unit 11. As a result, a portion of the component supply unit 11 close to the pallet pull-out table 23 is inserted into and attached to a unit attachment space 21 (see Fig. 4) of a component mounting machine 20.

As shown in Fig. 18, the leg 12 of each caster 24 is inserted into and supported by a cylindrical member 13 of the component supply unit 11 so as to be movable up and down. The leg 12 of each caster 24 is formed in the shape of a pipe, and a spring 14 (elastic member), which is raising force assist means for assisting a force for raising the component supply unit 11 generated by a unit-raising device 52 to be described below, is received in the leg 12. An upper portion of the leg 12 of each caster 24 is fitted to and supported by a fixing pipe 15, which is attached to the component supply unit 11 so as to extend downward, so as to be movable up and down. Accordingly, when the spring 14 is compressed by a lower end of the fixing pipe 15 and the fixing pipe 15 is pushed up by a resilient force of the spring 14, the force for raising the component supply unit 11 generated by the unit-raising devices 52 is assisted.

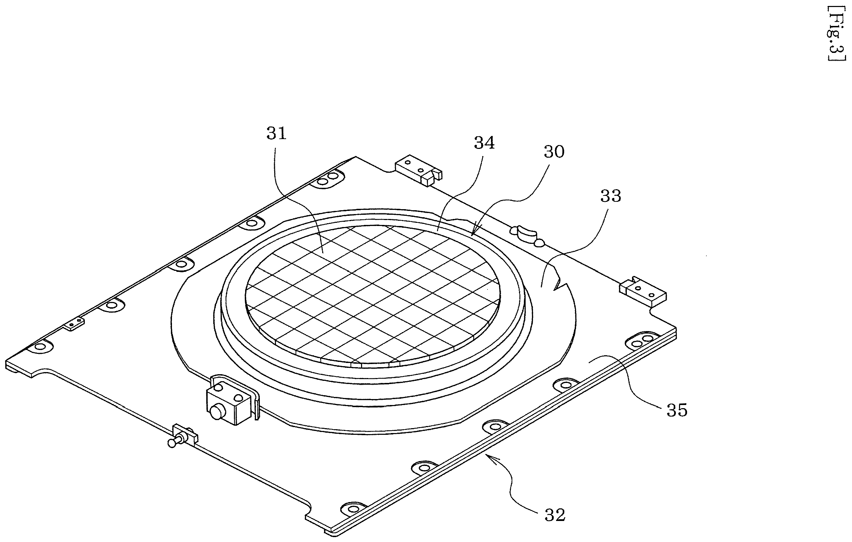

Meanwhile, wafer pallets 32 on which wafer extending bodies 30 are mounted are stacked in multiple stages on a magazine (not shown) that is received in the magazine holder 22 (see Fig. 1) of the component supply unit 11 so as to be movable up and down, and the wafer pallet 32 is pulled out onto the pallet pull-out table 23 from the magazine during production. As shown in Fig. 3, the wafer extending body 30 is a body in which a stretchable dicing sheet 34 to which dies 31 formed by dicing a wafer in a grid shape adhere is mounted on a wafer mounting plate 33 having a circular opening so as to expand, and the wafer mounting plate 33 is attached to a pallet body 35 by screwing or the like.

The push-up unit 28 (see Fig. 2) is adapted to be movable in X and Y directions in a spatial region that is present below the dicing sheet 34 of the wafer pallet 32. Further, an adhering portion of the die 31, which is to be picked up (sucked), of the dicing sheet 34 is locally pushed up from below by a push-up pin (not shown) of a push-up pot 37. Accordingly, the adhering portion of the die 31 is partially separated from the dicing sheet 34, and the die 31 floats so as to be easily picked up.

The push-up unit 28 uses a servo motor (not shown) as a driving source, and the entire push-up unit 28 is adapted to move up and down. When the push-up unit 28 moves up to a predetermined sheet suction position where an upper surface of the push-up pot 37 substantially comes into contact with the dicing sheet 34 of the wafer pallet 32 during an operation for picking up a die, the upward movement of the push-up unit 28 is stopped by a stopper mechanism (not shown). When the push-up unit 28 further continues to move up, the push-up pin protrudes upward from the upper surface of the push-up pot 37 and pushes up the adhering portion of the die 31, which is to be picked up, of the dicing sheet 34. In this case, it is possible to adjust the push-up height position (push-up distance) of the push-up pin by adjusting the rotation angle of a shaft of the servo motor serving as the driving source.

As shown in Fig. 1, a suction head 41 and a camera 42 are assembled in the X-Y moving mechanism 25, and the suction head 41 and the camera 42 are adapted to be integrally moved in the X and Y directions by the X-Y moving mechanism 25. The suction head 41 is provided with a suction nozzle (not shown) sucking the die 31 present on the dicing sheet 34 so that the suction nozzle moves up and down. The camera 42 can recognize the position of the die 31, which is to be sucked by the suction nozzle, by taking an image of the die 31 present on the dicing sheet 34 from above and processing the taken image.

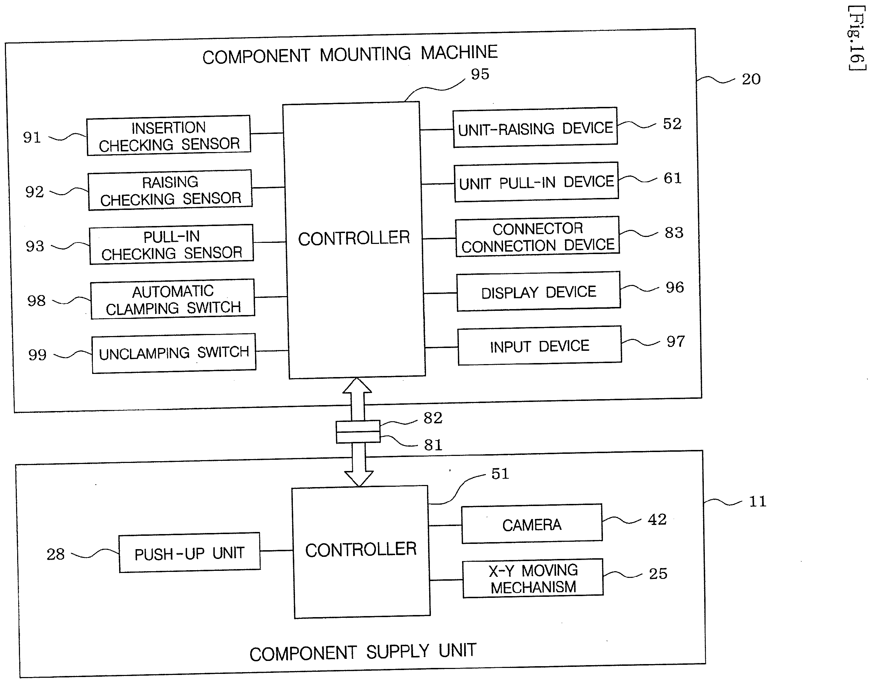

A controller 51 (see Fig. 16) of the component supply unit 11 recognizes the position of the die 31, which is to be sucked, among the dies 31 present on the dicing sheet 34 by processing an image, which is obtained by taking an image of the die 31 with the camera 42; determines the push-up position and the suction position of the die 31; and sucks the die 31 by the suction nozzle while allowing the die 31 to float so that the die 31 is easily picked up, by locally pushing up the adhering portion of the die 31, which is to be picked up (sucked), of the dicing sheet 34 from below with the push-up pin of the push-up pot 37 to partially separate the adhering portion of the die 31 from the dicing sheet 34.

Next, the structure of an attachment device, which inserts and attaches the component supply unit 11 to the unit attachment space 21 of the component mounting machine 20, will be described with reference to Figs. 4 to 16.

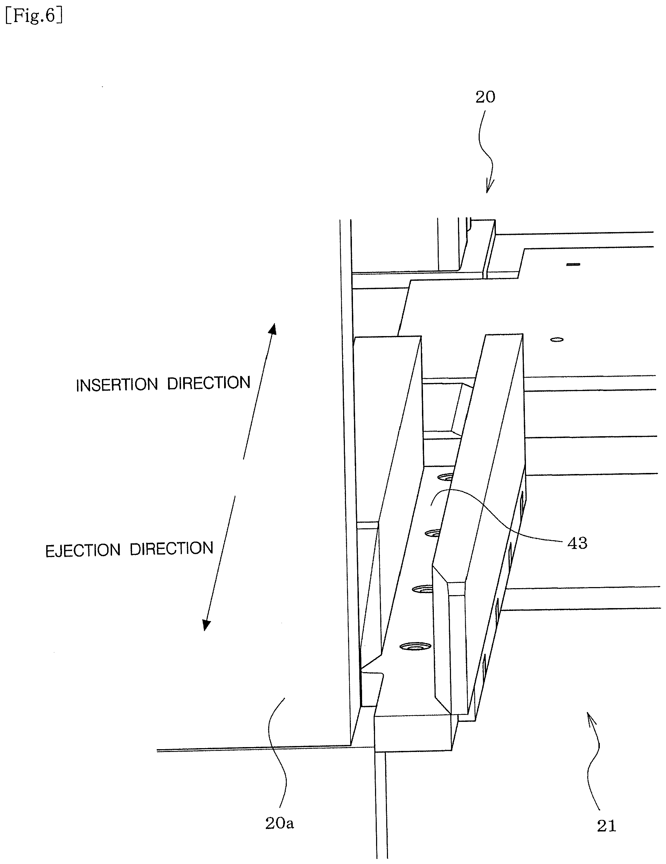

As shown in Figs. 4 and 6, unit insertion guide rails 43, which guide the insertion of the component supply unit 11 and are formed in the shape of a U-shaped groove, are fixed to lower portions of both left and right sides of the unit attachment space 21 of the component mounting machine 20 so as to extend in a forward-rearward direction (Y direction).

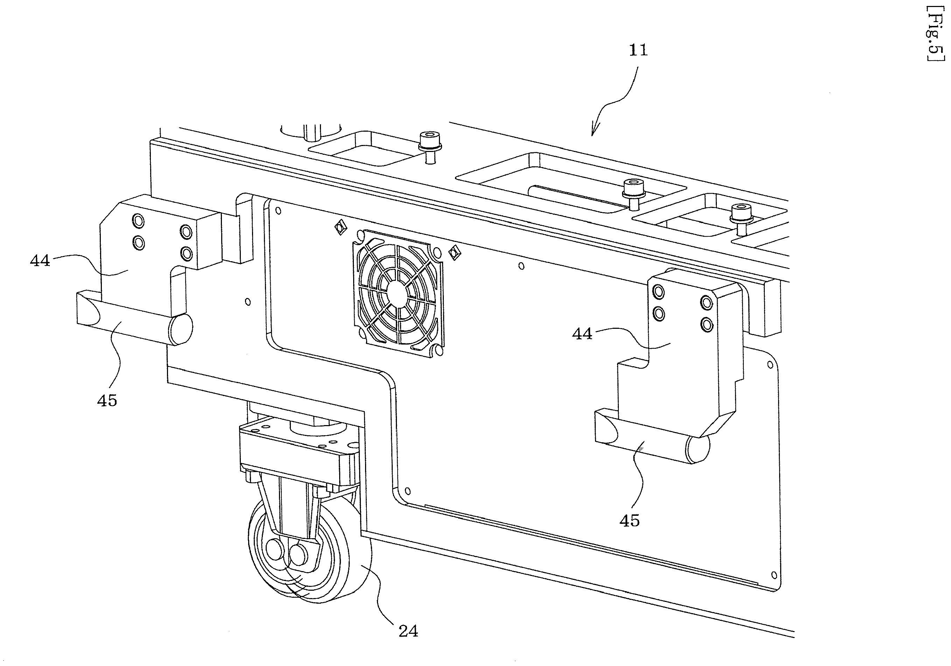

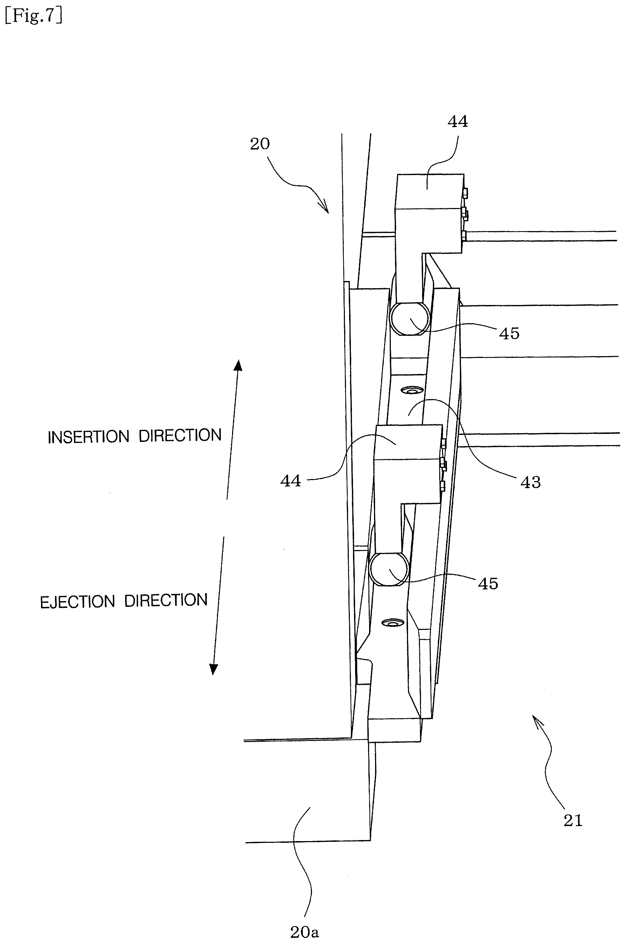

As shown in Figs. 1 and 5, a plurality of (for example, two) inverted L-shaped members 44, which are lined up in the forward-rearward direction (Y direction), are fixed to each of lower portions of both left and right surfaces of the component supply unit 11 so as to correspond to the unit insertion guide rail 43. An inserting-positioning slide member 45, which is formed in the shape of a round bar, is provided at the lower end portion of each inverted L-shaped member 44 so as to extend in the forward-rearward direction (Y direction) in parallel with the side surface of the component supply unit 11. Accordingly, when a worker inserts the component supply unit 11 into the unit attachment space 21 of the component mounting machine 20 by pushing the component supply unit 11, the worker can insert the component supply unit 11 into the unit attachment space 21 while positioning the component supply unit 11 relative to the unit attachment space 21 in a left-right direction by inserting the inserting-positioning slide members 45 into the unit insertion guide rail 43 as shown in Fig. 7.

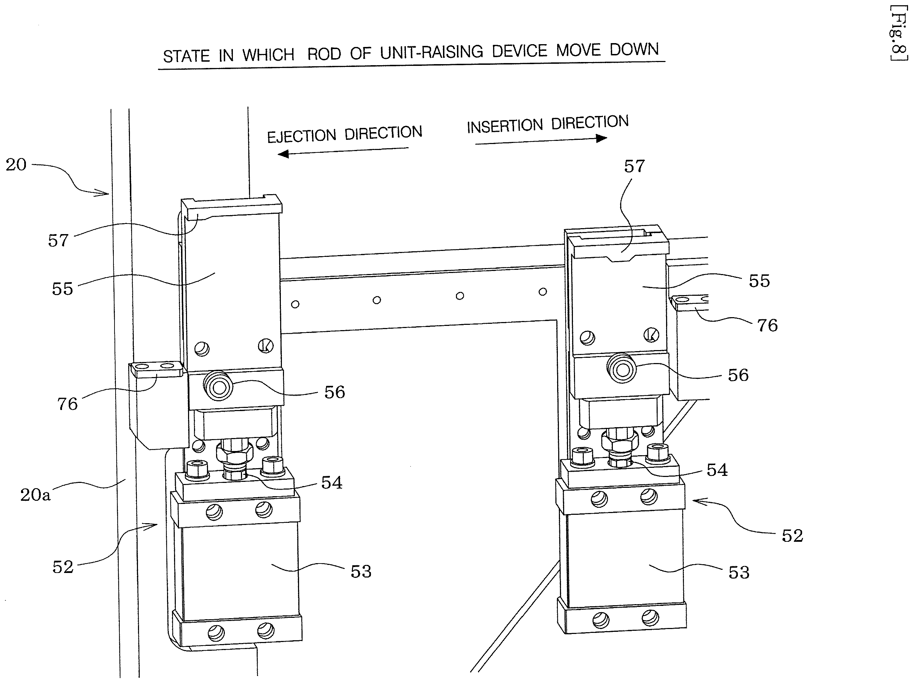

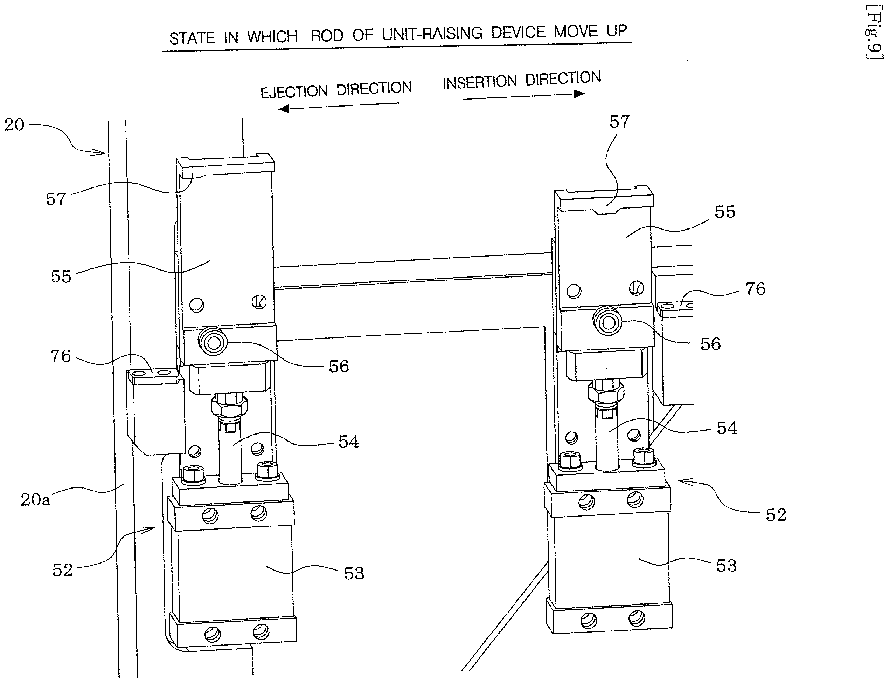

Further, as shown in Figs. 4 and 8, a plurality of (for example, two) unit-raising devices 52 (unit-raising means) are provided on each of both the left and right sides of the unit attachment space 21 of the component mounting machine 20 so as to be lined up in the forward-rearward direction (Y direction). As shown in Figs. 8 and 9, each of the unit-raising devices 52 is attached to a body frame 20a of the component mounting machine 20 so that a rod 54 of an air cylinder 53 serving as a driving source is directed upward, a lifting member 55 is fixed to an upper portion of the rod 54 by a screw or the like, and a support roller 56, which receives and supports the load of the component supply unit 11, is rotatably provided on the inner surface of the lifting member 55. The lifting member 55 also functions as a clamping member (clamping means), and a clamp pawl 57 is formed at an upper end portion of the lifting member 55 so as to protrude toward the inside of the unit attachment space 21.

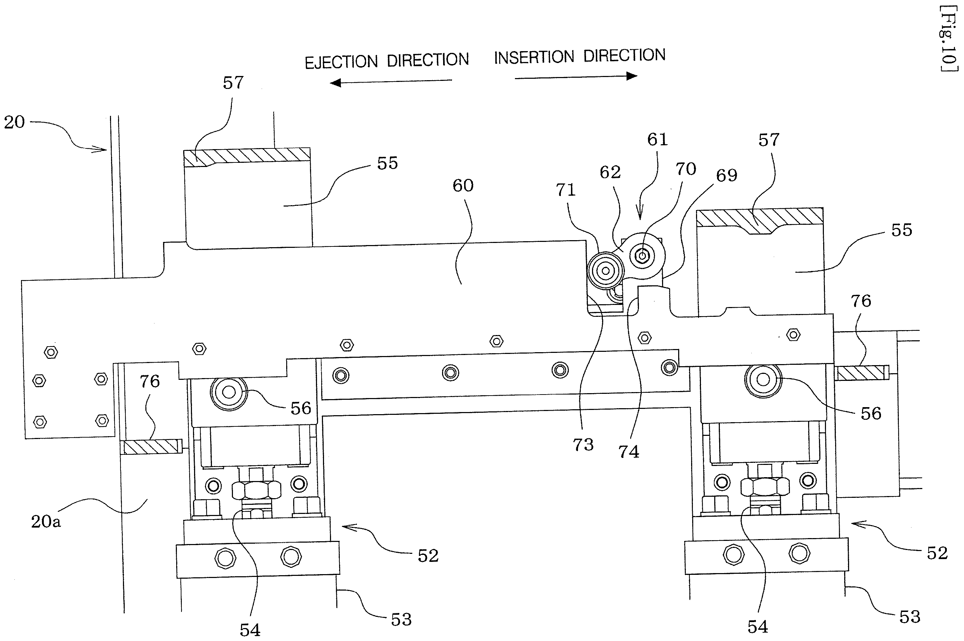

Since horizontally long fixing members 60, which extend in the forward-rearward direction (Y direction), are fixed to both the left and right surfaces of the component supply unit 11 so as to correspond to the lifting members 55 as shown in Fig. 1 and the fixing members 60 are received and supported by the support rollers 56 of the unit-raising devices 52 as shown in Fig. 10, the component supply unit 11 can be easily slid and moved in the forward-rearward direction (Y direction) by the rotation of the support rollers 56.

Unit pull-in devices 61 (see Figs. 10 to 13), which are unit pull-in means, are provided on both the left and right sides of the unit attachment space 21 of the component mounting machine 20. Each of the unit pull-in devices 61 includes a pull-in arm 62 that pulls in the component supply unit 11, and an air cylinder 64 that drives the pull-in arm 62. While a rod 65 of the air cylinder 64 is directed in a depth direction (an insertion direction of component supply unit 11), a bottom portion (a portion opposite to the rod 65) of the air cylinder 64 is rotatably supported by an attachment bracket 67 that is fixed to the body frame 20a of the component mounting machine 20 by a support shaft 66. Accordingly, the rod 65 can move up and down about the support shaft 66 serving as a fulcrum. The rod 65 of the air cylinder 64 and the pull-in arm 62 are connected to each other by a link mechanism 68. The pull-in arm 62 is rotatably supported through a rotating shaft 70 by an attachment bracket 69 that is fixed to the body frame 20a of the component mounting machine 20, and a pull-in roller 71 is rotatably provided at a tip portion of the pull-in arm 62. The pull-in arm 62 is rotated about the rotating shaft 70 in an insertion direction/ejection direction by a protruding/pull-in operation of the rod 65 of the air cylinder 64, so that the pull-in roller 71 provided at the tip portion of the pull-in arm 62 revolves in the insertion direction/ejection direction.

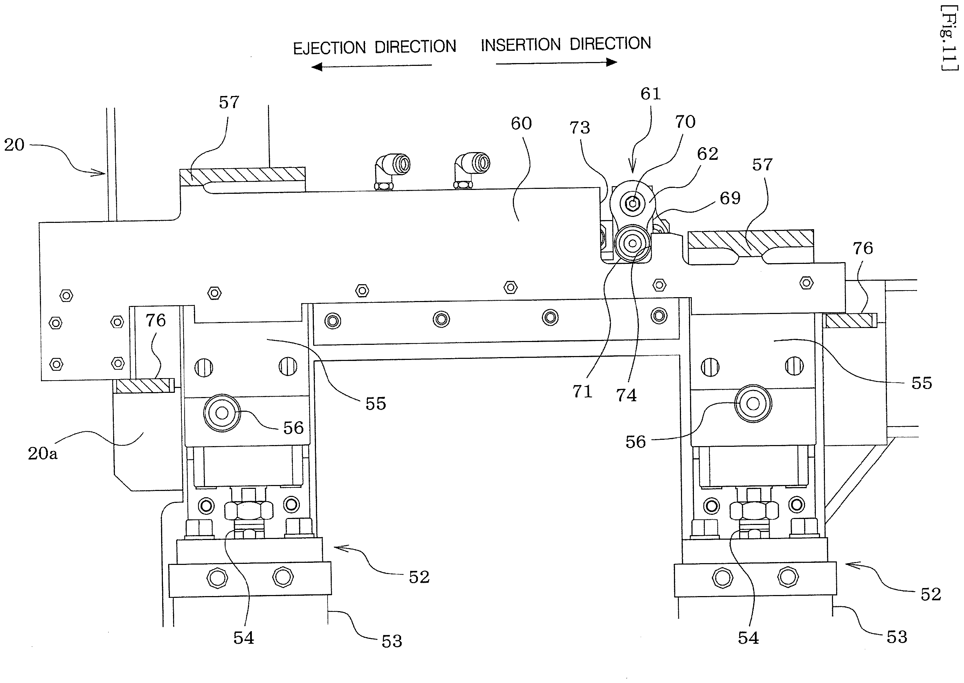

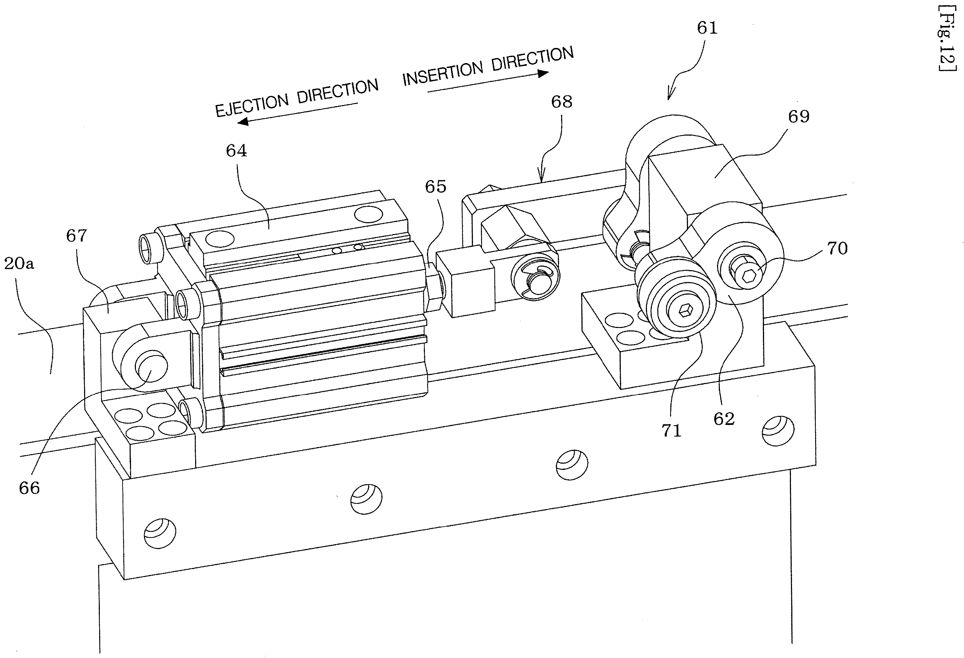

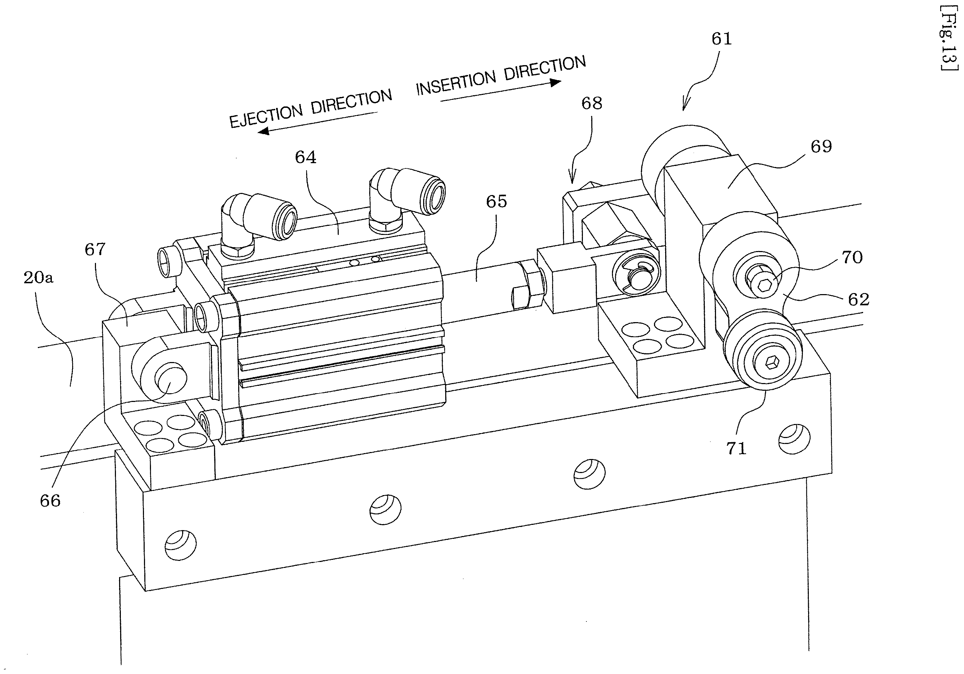

As shown in Figs. 10 and 11, two contact wall portions 73 and 74 are formed at each of the fixing members 60, which are fixed to both the left and right surfaces of the component supply unit 11, so as to correspond to the pull-in roller 71 and be positioned on both the front and rear sides of the pull-in roller 71 that is provided at the tip portion of the pull-in arm 62. Accordingly, when the rod 65 of the air cylinder 64 of the unit pull-in device 61 is pulled in as shown in Fig. 12, the pull-in roller 71 of the pull-in arm 62 comes into contact with the contact wall portion 73 that is formed on the side corresponding to the ejection direction (the side opposite to the insertion direction) as shown in Fig. 10 and the pull-in arm 62 is rotated toward the side corresponding to the ejection direction. Therefore, the component supply unit 11 is pushed in the ejection direction. Meanwhile, when the rod 65 of the air cylinder 64 of the unit pull-in device 61 protrudes in the insertion direction as shown in Fig. 13, the pull-in roller 71 of the pull-in arm 62 comes into contact with the contact wall portion 74 that is formed on the side corresponding to the insertion direction as shown in Fig. 11 and the pull-in arm 62 is rotated toward the side corresponding to the insertion direction. Therefore, the component supply unit 11 is pulled in the insertion direction.

Receiving members 76 (see Figs. 10 and 11), which receive and support the load of the component supply unit 11, are provided at two front and rear positions on each of both the left and right sides of the unit attachment space 21 of the component mounting machine 20, and both the front and rear end portions of the fixing members 60, which are provided on both the left and right surfaces of the component supply unit 11, are placed on the receiving members 76 as shown in Fig. 11, respectively. Accordingly, the height of the component supply unit 11 is positioned and the load of the component supply unit 11 is received and supported by the receiving members 76. In this state, the fixing members 60 are interposed between the receiving members 76 and the clamp pawls 57. As a result, the fixing members 60 are clamped and the attachment state of the component supply unit 11 can be maintained.

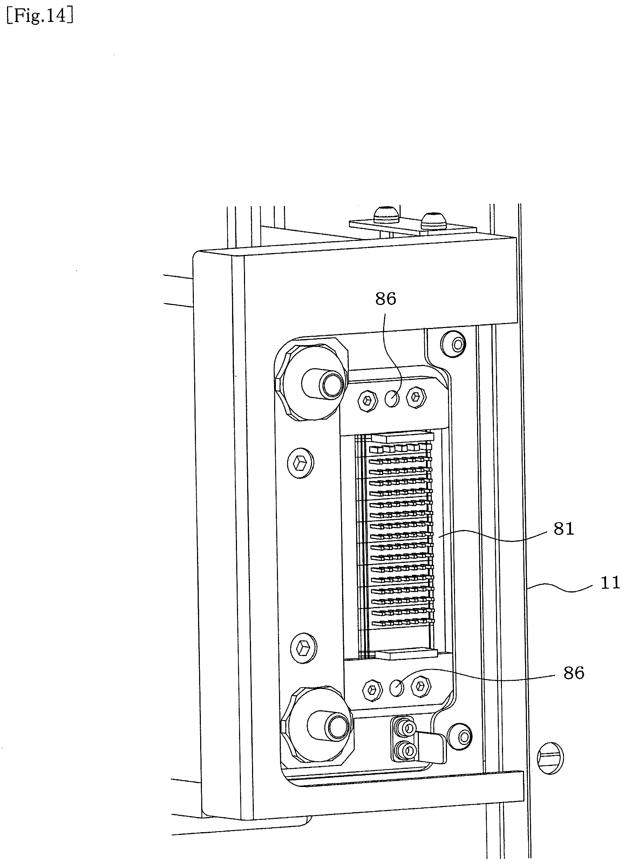

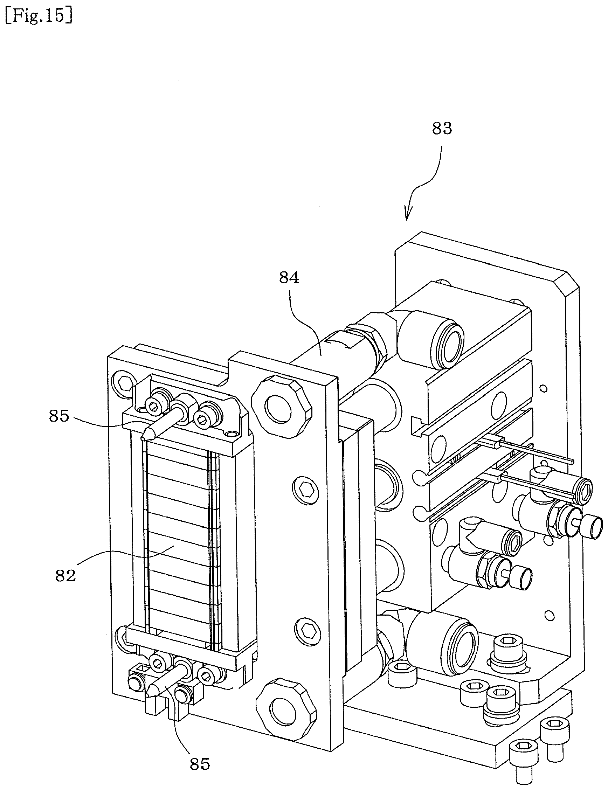

A connector 81 (see Fig. 14) of a communication line and/or a power line is provided at a predetermined position on the component supply unit 11. A connector connection device 83 (see Fig. 15), which connects a connector 82 of a communication line and/or a power line of the component mounting machine 20 to the connector 81 of the component supply unit 11, is provided at a predetermined position in the unit attachment space 21 of the component mounting machine 20 so as to correspond to the connector 81. The connector 82 of the connector connection device 83 is attached to a tip portion of a rod of an air cylinder 84 serving as a driving source, and positioning pins 85 are provided on both upper and lower sides of the connector 82 so as to protrude in an insertion-connection direction. Positioning holes 86 are formed on both upper and lower sides of the connector 81 of the component supply unit 11 so as to correspond to the positioning pins 85, respectively. After the component supply unit 11 is clamped, the air cylinder 84 of the connector connection device 83 is operated so that the rod of the air cylinder 84 protrudes. Accordingly, the positioning pins 85 of the component mounting machine 20 are inserted into the positioning holes 86, so that the position of the connector 82 of the component mounting machine 20 corresponds to the position of the connector 81 of the component supply unit 11 and the connectors 82 and 81 are connected to each other.

Meanwhile, an insertion checking sensor 91 (see Fig. 16) that checks the completion of an operation for inserting the component supply unit 11 into the unit attachment space 21, a raising checking sensor 92 (see Fig. 16) that checks the completion of an operation for raising the component supply unit 11 performed by the unit-raising devices 52, and a pull-in checking sensor 93 (see Fig. 16) that checks the completion of an operation for pulling in the component supply unit 11 performed by the unit pull-in devices 61 are provided at predetermined positions in the unit attachment space 21 of the component mounting machine 20. Each of the checking sensors 91 to 93 is formed of a non-contact type sensor (for example, a proximity sensor, an optical sensor, an infrared sensor, a photoelectric sensor, or the like) or a contact type sensor (for example, a limit switch, a contact type displacement sensor, or the like). An output signal of each of the checking sensors 91 to 93 is input to a controller 95 of the component mounting machine 20. A display device 96 that displays various kinds of information, and an input device 97, such as a keyboard, a mouse, and a touch panel, are connected to the controller 95 of the component mounting machine 20.

Further, an automatic clamping switch 98 (attachment operating switch) that is used to automatically clamp the component supply unit 11 inserted into the unit attachment space 21 and an unclamping switch 99 (removal operation switch) that releases clamping are provided in the component mounting machine 20 at positions that are close to an inlet of the unit attachment space 21 and are present within worker's reach, and signals of the automatic clamping switch 98 and the unclamping switch 99 are also input to the controller 95 of the component mounting machine 20. Lamps, display panels, or the like, which display information checked by the respective checking sensors 91 to 93, are provided in addition to the switches. These kinds of information may be displayed on the display device 96 of the component mounting machine 20, or may be notified to a worker by voice. Furthermore, the automatic clamping switch 98 and/or the unclamping switch 99 may be omitted, and instructions for automatically clamping and/or unclamping may be input to the controller 95 through the operation of the input device 97 connected to the controller 95 of the component mounting machine 20.

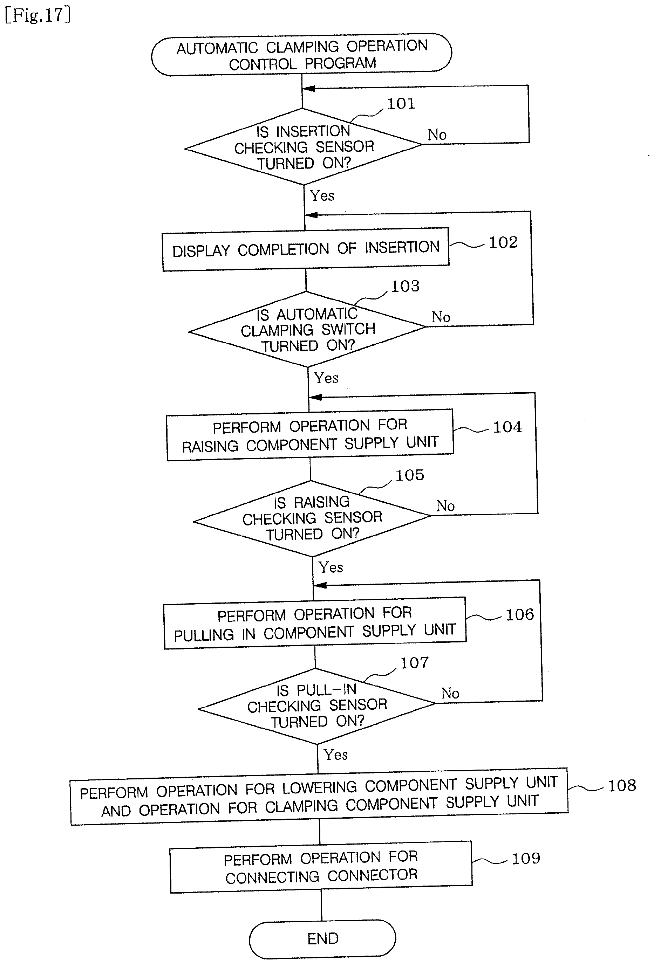

The controller 95 (control means) of the component mounting machine 20 controls the operation of the unit-raising device 52, the unit pull-in device 61, and the connector connection device 83 on the basis of output signals of the respective checking sensors 91 to 93, the automatic clamping switch 98, and the like through the execution of an automatic clamping operation control program of Fig. 17, and allows the component supply unit 11, which is inserted into the unit attachment space 21 of the component mounting machine 20, to be automatically clamped. Accordingly, a worker may have to only turn on the automatic clamping switch 98 by inserting the component supply unit 11 into the unit attachment space 21 of the component mounting machine 20, and the component supply unit 11 is automatically clamped according to the automatic clamping operation control program of Fig. 17 after the automatic clamping switch 98 is turned on. The content of the processing of the automatic clamping operation control program of Fig. 17 will be described below.

The automatic clamping operation control program of Fig. 17 is started after a power source of the controller 95 of the component mounting machine 20 is turned on. When this program is started, first, a process is on standby until the insertion checking sensor 91 is turned on (until work of inserting the component supply unit 11 into the unit attachment space 21 is completed) in Step 101. After that, when the insertion checking sensor 91 is turned on and the completion of the work of inserting the component supply unit 11 is checked, the process proceeds to Step 102, the completion of the work of inserting the component supply unit 11 is notified to the worker by the turn-on or flickering of the lamps, the display of the display panels or the like, or voice so that the worker is prompted to turn on the automatic clamping switch 98.

After that, the process proceeds to Step 103 and is on standby until the worker turns on the automatic clamping switch 98. Then, when the worker turns on the automatic clamping switch 98, the process proceeds to Step 104 and the unit-raising devices 52 are operated to move up to raise the component supply unit 11.

After that, the process proceeds to Step 105, and an operation for raising the component supply unit 11 continues to be performed until the raising checking sensor 92 is turned on. Then, when the raising checking sensor 92 is turned on and the completion of the operation for raising the component supply unit 11 is checked, the process proceeds to Step 106 and the unit pull-in devices 61 are operated to pull in the component supply unit 11 in the insertion direction.

After that, the process proceeds to Step 107 and the operation for pulling in the component supply unit 11 continues to be performed until the pull-in checking sensor 93 is turned on. Then, when the pull-in checking sensor 93 is turned on and the completion of the operation for pulling in the component supply unit 11 is checked, the process proceeds to Step 108 and the unit-raising devices 52 are operated to move down to lower the component supply unit 11. Accordingly, since the fixing members 60, which are provided on both the left and right surfaces of the component supply unit 11, are placed on the receiving members 76 of the component mounting machine 20 as shown in Fig. 11, the height of the component supply unit 11 is positioned and the load of the component supply unit 11 is received and supported by the receiving members 76. In this state, the fixing members 60 are interposed between the receiving members 76 and the clamp pawls 57, so that the component supply unit 11 is clamped.

After that, the process proceeds to Step 109 and the air cylinder 84 of the connector connection device 83 is operated so that the rod of the air cylinder 84 protrudes. Accordingly, the connector 82 of the component mounting machine 20 is inserted and connected to the connector 81 of the component supply unit 11, and this program ends. Therefore, the clamping of the component supply unit 11 is completed.

After that, if the worker turns on the unclamping switch 99 when removing the component supply unit 11 from the component mounting machine 20, the component supply unit 11 is automatically unclamped in the following manner in the reverse order to the order of the above-mentioned automatic clamping operation.

When an unclamping operation is started, first, the rod of the air cylinder 84 of the connector connection device 83 is pulled in, so that the connector 82 of the component mounting machine 20 is pulled out from the connector 81 of the component supply unit 11. After that, the unit-raising devices 52 are operated to move up to raise the clamp pawls 57, unclamp the fixing member 60, and raise the component supply unit 11.

Then, when the raising checking sensor 92 is turned on and the completion of the operation for raising the component supply unit 11 is checked, the component supply unit 11 is pushed out in the ejection direction by an operation for extruding the unit pull-in device 61. When the completion of the operation for extruding the component supply unit 11 is checked, the unit-raising devices 52 are operated to lower the component supply unit 11.

When the operation for lowering the component supply unit 11 is completed, the insertion checking sensor 91 is turned on and the completion of an operation for automatically unclamping the component supply unit 11 is notified to the worker by the turn-on or flickering of the lamps, the display of the display panels or the like, or voice so that the worker is prompted to pull out the component supply unit 11 from the unit attachment space 21 of the component mounting machine 20. After that, the worker can pull out the component supply unit 11 from the unit attachment space 21 of the component mounting machine 20 by gripping and pulling a handle or the like of the component supply unit 11.

Meanwhile, an extrusion checking sensor (a non-contact type sensor or a contact type sensor) may be provided to check the completion of the operation for extruding the component supply unit 11.

According to the above-mentioned embodiment, an automatic clamping mechanism, which automatically clamps the component supply unit 11 inserted into the unit attachment space 21 of the component mounting machine 20, is provided. Accordingly, even though the floor of the unit attachment space 21 of the component mounting machine 20 is not flat or is inclined, not only a slope or the like does not need to be formed on the floor but also a worker does not need to perform work of adjusting the levelness of the component supply unit 11 by adjusting the height of each caster 24 and the worker has to only perform work of inserting the component supply unit 11 into the unit attachment space 21 of the component mounting machine 20. After that, it is possible to automatically perform a series of operations for raising the component supply unit 11 by the unit-raising devices 52, pulling the component supply unit 11 into the component mounting machine 20 by the unit pull-in devices 61, lowering the component supply unit 11 to a predetermined height position by the unit-raising devices 52, positioning the component supply unit 11 relative to the component mounting machine 20, and clamping the component supply unit 11 by the clamp pawls 57. Accordingly, since it is possible to achieve the reduction of the labor of work of attaching the component supply unit 11 and the shortening of the working time and to insert the component supply unit 11 into the unit attachment space 21 of the component mounting machine 20 without using a slope, work of inserting the component supply unit 11 into the unit attachment space 21 of the component mounting machine 20 becomes easy. Therefore, it is possible to prevent damage to the device during the work, and to perform work of attaching the component supply unit 11 even in a relatively small working space. As a result, it is possible to achieve space saving.

Moreover, in this embodiment, the component supply unit 11 is supported by the casters 24 so as to be movable up and down and the legs 12 supporting the casters 24 are provided with the springs 14 that assist a force for raising the component supply unit 11 generated by the unit-raising devices 52. Accordingly, since the force for raising the component supply unit 11 generated by the unit-raising devices 52 can be assisted by the resilient forces of the springs 14 even though the weight of the component supply unit 11 is large, the raising force of the unit-raising devices 52 can be reduced. Therefore, the unit-raising devices 52 can be made to be compact.

Further, in this embodiment, the clamp pawls 57 (clamping means) are formed at the upper end portions of the lifting members 55 of the unit-raising devices 52, the fixing members 60 of the component supply unit 11 are placed on the receiving members 76 of the component mounting machine 20, the clamp pawls 57 are lowered by the unit-raising devices 52 while the component supply unit 11 is supported by the receiving members 76, and the fixing members 60 are clamped by the clamp pawls 57 while being interposed between the receiving members 76 and the clamp pawls. Accordingly, the power source (air cylinder 53) of the unit-raising device 52 can be used as the power source of the clamp pawl 57. Therefore, it is possible to simplify the structure of the clamping means.

However, the invention is not limited to this structure, and the clamping means may be adapted to be driven by a dedicated power source.

Further, in the above-mentioned embodiment, an air cylinder has been used as the unit-raising device 52, the unit pull-in device 61, the connector connection device 83, and the driving source of the clamping member, but other actuators, such as a hydraulic cylinder and a motor, may be used.

Furthermore, the component supply unit, which is attached to the unit attachment space 21 of the component mounting machine 20, is not limited to only the component supply unit 11 that supplies dies (wafer components). The invention may be applied likewise when a component supply unit in which a plurality of tape feeders are mounted on a cart, a component supply unit where tray pallets on which tray components are stacked are received in a magazine in multiple stages, a component supply unit in which wafer pallets on which wafer components are placed and tray pallets on which tray components are placed are placed together in multiple stages, or the like is to be attached.

Moreover, it goes without saying that the structure of the unit-raising device 52, the unit pull-in device 61, the connector connection device 83, and the clamping means (clamping member) may be appropriately modified, that is, the invention may have various modifications without departing from the scope of the invention. The invention is defined by the claims.

### Reference Number List

11: component supply unit, 12: leg, 14: spring (raising force assist means), 15: fixing pipe, 20: component mounting machine, 20a: body frame, 21: unit attachment space, 24: caster, 30: wafer extending body, 31: die, 32: wafer pallet, 34: dicing sheet, 41: suction head, 43: unit insertion guide rail, 45: inserting-positioning slide member, 51: controller of component supply unit, 52: unit-raising device (unit-raising means), 53: air cylinder, 55: lifting member (clamping member), 56: support roller, 57: clamp pawl (clamping member), 60: fixing member, 61: unit pull-in device (unit pull-in means), 62: pull-in arm, 64: air cylinder, 71: pull-in roller, 73, 74: contact wall portion, 76: receiving member, 81, 82: connector, 83: connector connection device, 84: air cylinder, 85: positioning pin, 86: positioning hole, 91: insertion checking sensor, 92: raising checking sensor, 93: pull-in checking sensor, 95: controller (control means) of component mounting machine, 96: display device, 97: input device, 98: automatic clamping switch, 99: unclamping switch

## Claims

1. A device for attaching a component supply unit (11) to a component mounting machine (20) by inserting the component supply unit (11), which includes casters (24), into a unit attachment space (21) of the component mounting machine (20),
wherein the component mounting machine (20) includes unit-raising means (52) for raising the component supply unit (11) inserted into the unit attachment space (21), unit pull-in means (61) for pulling the component supply unit (11), which has been raised by the unit-raising means (52), into the component mounting machine (20), and clamping means (57, 76) for lowering the component supply unit (11), which has been pulled in by the unit pull-in means (61), to a predetermined height position by the unit-raising means (52), and clamping the component supply unit (11), and
wherein the clamping means includes clamping members (57) that are provided on the unit-raising means (52) and receiving members (76) that are provided on the component mounting machine (20), and is adapted to lower the clamping members (57) by the unit-raising means (52) while fixing members (60) of the component supply unit (11) are placed on the receiving members (76) and the component supply unit (11) is supported by the receiving members (76), and is adapted to clamp the fixing members (60) by the clamping members (57) while the fixing members (60) are interposed between the receiving members (76) and the clamping members (57).

2. The device for attaching a component supply unit (11) to a component mounting machine (20) according to claim 1,
wherein the component supply unit (11) is supported by the casters (24) so as to be movable up and down, and
each of the casters (24) is provided with raising force assist means (14) for assisting a force for raising the component supply unit (11) generated by the unit-raising means (52).

3. The device for attaching a component supply unit (11) to a component mounting machine (20) according claim 1 or 2,
wherein the component mounting machine (20) includes an insertion checking sensor (91) that is adapted to check the insertion of the component supply unit (11) into the unit attachment space (21), a raising checking sensor (92) that is adapted to check the raising of the component supply unit (11), which is performed by the unit-raising means (52), and a pull-in checking sensor (93) that is adapted to check the pull-in of the component supply unit (11), which is performed by the unit pull-in means (61).

4. The device for attaching a component supply unit (11) to a component mounting machine (20) according to claim 3,
wherein the component mounting machine (20) includes control means (95) for controlling an operation of the unit-raising means (52) and the unit pull-in means (61), and
the control means (95) is adapted to perform an operation for raising the component supply unit (11), which is performed by the unit-raising means (52), after the insertion of the component supply unit (11) into the unit attachment space (21) of the component mounting machine (20) is checked by the insertion checking sensor (91); is adapted to perform an operation for pulling in the component supply unit (11), which is performed by the unit pull-in means (61), after the completion of the operation for raising the component supply unit (11), which is performed by the unit-raising means (52), is checked by the raising checking sensor (92); and is adapted to lower the component supply unit (11) to a predetermined height position by the unit-raising means (52) and is adapted to clamp the component supply unit (11) by the clamping means (57, 76) after the completion of the operation for pulling in the component supply unit (11) is checked by the pull-in checking sensor (93).

5. The device for attaching a component supply unit (11) to a component mounting machine (20) according to any one of claims 1 to 4,
wherein the component mounting machine (20) includes a connector connection device (83) that is adapted to insert and connect a connector (82) of a communication line and/or a power line of the component mounting machine (20) to a connector (81) of the component supply unit (11) while the component supply unit (11) is clamped by the clamping means (57, 76).

## Patentansprüche

1. Vorrichtung zum Anbringen einer Einheit (11) zur Zufuhr von Bauteilen an einer Maschine (20) zum Montieren von Bauteilen durch Einführen der Einheit (11) zur Zufuhr von Bauteilen, die Laufrollen (24) enthält, in einen Raum (21) zur Anbringung der Einheit der Maschine (20) zum Montieren von Bauteilen,
wobei die Maschine (20) zum Montieren von Bauteilen eine Einrichtung (52) zum Anheben der Einheit, mit der die in den Raum (21) zur Anbringung der Einheit eingeführte Einheit (11) zur Zufuhr von Bauteilen angehoben wird, eine Einrichtung (61) zum Einziehen der Einheit, mit der die Einheit (11) zur Zufuhr von Bauteilen, die durch die Einrichtung (52) zum Anheben der Einheit angehoben worden ist, in die Maschine (20) zum Montieren von Bauteilen hineingezogen wird, sowie Klemmeinrichtungen (57, 76) zum Absenken der Einheit (11) zur Zufuhr von Bauteilen, die durch die Einrichtung (61) zum Einziehen der Einheit eingezogen worden ist, an eine vorgegebene Höhenposition mittels der Einrichtung (52) zum Anheben der Einheit und zum Festklemmen der Einheit (11) zur Zufuhr von Bauteilen enthält, und
wobei die Klemmeinrichtungen Klemmelemente (57), die an der Einrichtung (52) zum Anheben der Einheit vorhanden sind, sowie Aufnahmeelemente (76) enthalten, die an der Maschine (20) zum Montieren von Bauteilen vorhanden sind, und so eingerichtet sind, dass sie die Klemmelemente (57) mittels der Einrichtung (52) zum Anheben der Einheit absenkt, wenn Befestigungselemente (60) der Einheit (11) zur Zufuhr von Bauteilen an den Aufnahmeelementen (76) positioniert sind und die Einheit (11) zur Zufuhr von Bauteilen von den Aufnahmeelementen (76) getragen wird, und so eingerichtet sind, dass sie die Befestigungselemente (60) mittels der Klemmelemente (57) festklemmen, wenn die Befestigungselemente (60) zwischen den Aufnahmeelementen (76) und den Klemmelementen (57) angeordnet sind.

2. Vorrichtung zum Anbringen einer Einheit (11) zur Zufuhr von Bauteilen an einer Maschine (20) zum Montieren von Bauteilen nach Anspruch 1,
wobei die Einheit (11) zur Zufuhr von Bauteilen von den Laufrollen (24) so getragen wird, dass sie nach oben und nach unten bewegt werden kann, und
jede der Rollen (24) mit einer Einrichtung (14) zum Unterstützen einer Anhebe-Kraft versehen ist, mit der eine durch die Einrichtung (52) zum Anheben der Einheit erzeugte Kraft zum Anheben der Einheit (11) zur Zufuhr von Bauteilen unterstützt wird.

3. Vorrichtung zum Anbringen einer Einheit (11) zur Zufuhr von Bauteilen an einer Maschine (20) zum Montieren von Bauteilen nach Anspruch 1 oder 2,
wobei die Maschine (20) zum Montieren von Bauteilen einen Sensor (91) zum Prüfen von Einführung, der zum Prüfen der Einführung der Einheit (11) zur Zufuhr von Bauteilen in den Raum (21) zur Anbringung der Einheit eingerichtet ist, einen Sensor (92) zum Prüfen von Anheben, der zum Prüfen des Anhebens der Einheit (11) zur Zufuhr von Bauteilen eingerichtet ist, das durch die Einrichtung (52) zum Anheben der Einheit durchgeführt wird, sowie einen Sensor (93) zum Prüfen von Einziehen enthält, der zum Prüfen des Einziehens der Einheit (11) zur Zufuhr von Bauteilen eingerichtet ist, das durch die Einrichtung (61) zum Einziehen der Einheit durchgeführt wird.

4. Vorrichtung zum Anbringen einer Einheit (11) zur Zufuhr von Bauteilen an einer Maschine (20) zum Montieren von Bauteilen nach Anspruch 3,
wobei die Maschine (20) zum Montieren von Bauteilen eine Steuerungseinrichtung (95) enthält, mit der eine Funktion der Einrichtung (52) zum Anheben der Einheit und der Einrichtung (61) zum Einziehen der Einheit gesteuert wird, und
die Steuerungseinrichtung (95) so eingerichtet ist, dass sie einen Vorgang zum Anheben der Einheit (11) zur Zufuhr von Bauteilen durchführt, der durch die Einrichtung (52) zum Anheben der Einheit durchgeführt wird, nachdem die Einführung der Einheit (11) zur Zufuhr von Bauteilen in den Raum (21) zur Anbringung der Einheit der Maschine (20) zum Montieren von Bauteilen durch den Sensor (91) zum Prüfen von Einführung geprüft worden ist; so eingerichtet ist, dass sie einen Vorgang zum Einziehen der Einheit (11) zur Zufuhr von Bauteilen durchführt, der durch die Einrichtung (61) zum Einziehen der Einheit durchgeführt wird, nachdem der Abschluss des Vorgangs zum Anheben der Einheit (11) zur Zufuhr von Bauteilen, der durch die Einrichtung (52) zum Anheben der Einheit durchgeführt wird, durch den Sensor (92) zum Prüfen von Anheben geprüft worden ist; und so eingerichtet ist, dass sie die Einheit (11) zur Zufuhr von Bauteilen mittels der Einrichtung (52) zum Anheben der Einheit auf eine vorgegebene Höhenposition absenkt, und so eingerichtet ist, dass sie die Einheit (11) zur Zufuhr von Bauteilen mittels der Klemmeinrichtungen (57, 76) festklemmt, nachdem der Abschluss des Vorgangs zum Einziehen der Einheit (11) zur Zufuhr von Bauteilen durch den Sensor (93) zum Prüfen von Einziehen geprüft worden ist.

5. Vorrichtung zum Anbringen einer Einheit (11) zur Zufuhr von Bauteilen an einer Maschine (20) zum Montieren von Bauteilen nach einem der Ansprüche 1 bis 4,
wobei die Maschine (20) zum Montieren von Bauteilen eine Vorrichtung (83) zur Verbindung eines Verbinders aufweist, die so eingerichtet ist, dass sie einen Verbinder (82) einer Kommunikationsleitung und/oder einer Stromleitung der Maschine (20) zum Montieren von Bauteilen einführt und mit einem Verbinder (81) der Einheit (11) zur Zufuhr von Bauteilen verbindet, wenn die Einheit (11) zur Zufuhr von Bauteilen durch die Klemmeinrichtungen (57, 76) festgeklemmt wird.

## Revendications

1. Dispositif pour fixer une unité d'alimentation en composants (11) à une machine de montage de composants (20) en insérant l'unité d'alimentation en composants (11), qui comprend des roulettes (24), dans un espace de fixation d'unité (21) de la machine de montage de composants (20),
dans lequel la machine de montage de composants (20) comprend des moyens de soulèvement d'unité (52) pour soulever l'unité d'alimentation en composants (11) insérée dans l'espace de fixation d'unité (21), des moyens de traction d'unité (61) pour tirer l'unité d'alimentation en composants (11), qui a été soulevée par les moyens de soulèvement d'unité (52), dans la machine de montage de composants (20), et des moyens de serrage (57, 76) pour abaisser l'unité d'alimentation en composants (11), qui a été tirée par les moyens de traction d'unité (61), à une position en hauteur prédéterminée par les moyens de soulèvement d'unité (52), et pour serrer l'unité d'alimentation en composants (11), et
dans lequel les moyens de serrage comprennent des éléments de serrage (57) qui sont agencés sur les moyens de soulèvement d'unité (52) et des éléments de réception (76) qui sont agencés sur la machine de montage de composants (20), et sont adaptés pour abaisser les éléments de serrage (57) par les moyens de soulèvement d'unité (52) alors que des éléments de fixation (60) de l'unité d'alimentation en composants (11) sont placés sur les éléments de réception (76) et l'unité d'alimentation en composants (11) est supportée par les éléments de réception (76), et est adaptée pour serrer les éléments de fixation (60) par les éléments de serrage (57) alors que les éléments de fixation (60) sont interposés entre les éléments de réception (76) et les éléments de serrage (57).

2. Dispositif de fixation d'une unité d'alimentation en composants (11) à une machine de montage de composants (20) selon la revendication 1,
dans lequel l'unité d'alimentation en composants (11) est supportée par les roulettes (24) de manière à être mobile vers le haut et le bas, et
chacune des roulettes (24) est munie de moyens d'assistance de force de soulèvement (14) pour assister une force de soulèvement de l'unité d'alimentation en composants (11) générée par les moyens de soulèvement d'unité (52).

3. Dispositif de fixation d'une unité d'alimentation en composants (11) à une machine de montage de composants (20) selon la revendication 1 ou 2,
dans lequel la machine de montage de composants (20) comprend un capteur de contrôle d'insertion (91) qui est adapté pour vérifier l'insertion de l'unité d'alimentation en composants (11) dans l'espace de fixation d'unité (21), un capteur de contrôle de soulèvement (92) qui est adapté pour vérifier le soulèvement de l'unité d'alimentation en composants (11), qui est réalisé par les moyens de soulèvement d'unité (52), et un capteur de contrôle de traction (93) qui est adapté pour vérifier la traction de l'unité d'alimentation en composants (11), qui est réalisée par les moyens de traction d'unité (61).

4. Dispositif de fixation d'une unité d'alimentation en composants (11) à une machine de montage de composants (20) selon la revendication 3,
dans lequel la machine de montage de composants (20) comprend des moyens de commande (95) pour commander une opération des moyens de soulèvement d'unité (52) et des moyens de traction d'unité (61), et
les moyens de commande (95) sont adaptés pour effectuer une opération de soulèvement de l'unité d'alimentation en composants (11), qui est réalisée par les moyens de soulèvement d'unité (52), après que l'insertion de l'unité d'alimentation en composants (11) dans l'espace de fixation d'unité (21) de la machine de montage de composants (20) ait été vérifiée par le capteur de contrôle d'insertion (91); sont adaptés pour effectuer une opération de traction dans l'unité d'alimentation en composants (11), qui est effectuée par les moyens de traction d'unité (61), après que l'achèvement de l'opération de soulèvement de l'unité d'alimentation en composants (11), qui est effectuée par les moyens de soulèvement d'unité (52), ait été vérifié par le capteur de contrôle de soulèvement (92) ; et sont adaptés pour abaisser l'unité d'alimentation en composants (11) à une position en hauteur prédéterminée par les moyens de soulèvement d'unité (52) et sont adaptés pour serrer l'unité d'alimentation en composants (11) par les moyens de serrage (57, 76) après que l'achèvement de l'opération de traction de l'unité d'alimentation en composants (11) ait été vérifié par le capteur de contrôle de traction (93).

5. Dispositif de fixation d'une unité d'alimentation en composants (11) à une machine de montage de composants (20) selon l'une quelconque des revendications 1 à 4, dans lequel la machine de montage de composants (20) comprend un dispositif de connexion de connecteur (83) qui est adapté pour insérer et connecter un connecteur (82) d'une ligne de communication et/ou d'une ligne électrique de la machine de montage de composants (20) à un connecteur (81) de l'unité d'alimentation en composants (11) alors que l'unité d'alimentation en composants (11) est serrée par les moyens de serrage (57, 76).
